# FASCICULE DE BREVET EUROPEEN

(11) **EP 4 198 823 B1**
(45) Date de publication et mention de la délivrance du brevet: **01.11.2023**
(21) Numéro de dépôt: 22155993.3
(22) Date de dépôt: 09.02.2022
(51) Int. Cl.: G06K 19/077

(54) **CARTE A PUCE AVEC ANTENNES RADIOFREQUENCES**
CHIPKARTE MIT FUNKFREQUENZANTENNEN
SMART CARD WITH RADIO ANTENNAS

(30) Priorité: 17.12.2021 FR 2113850
(43) Date de publication de la demande: 21.06.2023
(73) Titulaire: IDEMIA The Netherlands B.V., 2000 GH Haarlem (NL)
(72) Inventeur: ALI, Ahmed, 2000GH HAARLEM (NL)
(74) Mandataire: Idemia

(56) Documents cités:
- US-A1- 2014 209 691
- US-A1- 2015 269 477
- US-A1- 2021 081 748

## Description

### Domaine Technique

L'invention se rapporte au domaine des cartes à puce et porte plus particulièrement sur les cartes à puce métalliques aptes à fonctionner en mode sans contact.

### Technique antérieure

L'utilisation des cartes à puce (ou cartes à microcircuit) est aujourd'hui largement répandue dans la vie quotidienne. De telles cartes sont par exemple utilisées comme cartes bancaires, cartes de fidélité, cartes d'accès etc., et peuvent prendre divers formats selon leurs utilisations respectives. Les cartes à puce peuvent être conçues pour réaliser divers types de fonctions, notamment pour effectuer des transactions, telles que des transactions bancaires (transaction de paiement, de transfert...), des transactions d'authentification, etc.

De façon connue, une carte à puce comprend généralement un corps de carte qui est équipé d'une puce électronique configurée pour échanger des signaux avec l'extérieur et réaliser diverses fonctions selon l'utilisation souhaitée de la carte. Pour ce faire, les cartes à puce sont munies de moyens de communication permettant d'interagir avec l'extérieur, typiquement avec un terminal ou lecteur externe.

Traditionnellement, une carte à puce est conçue pour coopérer avec un terminal externe au moyen de contacts externes accessibles à la surface de la carte. Un terminal externe peut ainsi positionner des broches de contact appropriées sur les contacts externes de la carte afin d'établir une communication par contact.

Plus récemment, les cartes à puce sans contact ont connu un essor croissant en raison du gain en rapidité et en simplicité liées aux transactions sans contact. Pour ce faire, les cartes sans contact embarquent une antenne radiofréquence (RF) permettant l'échange de signaux RF avec un terminal externe (par exemple en champ proche NFC pour « Near Field Communication » en anglais). Cette antenne RF est généralement composée d'une pluralité de spires conductrices qui s'étendent dans le corps de la carte.

La structure et l'apparence des cartes à puce peuvent varier selon le cas. Les cartes à puce métalliques connaissent en particulier un intérêt croissant. Il a été observé que les cartes à puce métalliques sont plus robustes faces aux stress mécaniques et sont donc moins susceptibles de rompre ou de s'endommager.

En outre, il existe une demande croissante pour les cartes à puce métalliques en raison notamment de l'aspect esthétique attractif de ces cartes (reflets métalliques, effet brossé en surface etc.), de l'impression de qualité qu'elles peuvent procurer (poids appréciable du métal, esthétique haute gamme), ou encore de la connotation de prestige qui y est associée pour leurs utilisateurs. En raison notamment de leur poids important et de l'impression de haute qualité qu'elles dégagent, ces cartes sont privilégiées par certains utilisateurs pour servir de marqueur social et d'élément différenciant.

Il a cependant été observé que la présence de métal dans le corps d'une carte à puce pose des difficultés majeures lorsque la carte embarque une antenne RF pour fonctionner en sans contact. Le métal agit comme blindage électromagnétique et bloque ou gêne les signaux RF échangés par l'antenne RF avec l'extérieur. Le métal présent dans le corps de carte peut ainsi perturber les communications sans contact d'une carte à puce avec un terminal externe et gêner par exemple la réalisation d'une transaction sans contact (de paiement ou autre).

Les solutions actuelles ne permettent pas toujours d'assurer des communications efficaces en sans contact d'une carte à puce métallique avec un terminal externe, et complexifient la structure et donc la fabrication des cartes à puce. Ainsi, il est connu d'incorporer une couche de ferrite entre l'antenne RF et la couche métallique de la carte à puce, mais cette solution rend la fabrication de la carte plus complexe et ne résout généralement pas le problème en ce que la carte est incapable de communiquer depuis l'une de ses faces avec un terminal externe.

Il existe donc un besoin pour des cartes à puce métalliques performantes (de type RFID par exemple) et de fabrication simple, capables de coopérer efficacement en sans contact avec un terminal externe, et ce quelle que soit l'orientation de la carte vis-à-vis du terminal externe.

US 2021/081748 A1 divulgue une carte à puce comprenant : un corps en métal comprenant une ouverture avec une fente ; une antenne amplificatrice composée d'une première partie s'étendant en périphérique du corps métallique, d'une deuxième partie s'étendant en périphérie de l'ouverture, et d'une troisième partie localisée au niveau de la fente.

US 2015/269477 A1 et US 2014/209691 A1 divulguent une carte à puce comprenant un corps de carte ; une puce RF ; un module d'antenne disposé dans une zone d'évidement ; une antenne amplificatrice comprenant une antenne de carte en périphérie du corps de carte, l'antenne amplificatrice comprenant également une antenne de couplage, en périphérie de la zone d'évidement.

### Exposé de l'invention

A cet effet, la présente invention concerne une carte à puce comprenant :
- un corps de carte formé au moins en partie par une couche métallique, ladite couche métallique comprenant une zone d'évidement débouchant sur un bord périphérique de la couche métallique, ladite couche métallique comprenant une fente connectant la zone d'évidemment au bord périphérique de la couche métallique ;
- une puce RF ;
- une première antenne RF disposée dans ou en regard de la zone d'évidement, ladite première antenne RF étant connectée électriquement à la puce RF ; et
- une deuxième antenne RF comprenant :
   ∘ une première partie d'antenne s'étendant en regard de la couche métallique pour collecter un courant image induit par des premiers courants de Foucault circulant dans la couche métallique ; et
   ∘ une deuxième partie d'antenne, connectée électriquement à la première partie d'antenne
   les première partie d'antenne et deuxième partie d'antenne (AT2b) comprennent des spires,
   caractérisé en ce que :
      la deuxième antenne est isolée électriquement de la couche métallique et de la première antenne,
   la deuxième partie d'antenne s'étend en regard de la zone d'évidement pour permettre un couplage magnétique entre la première antenne RF et la deuxième antenne RF, et
   ladite carte à puce permettant à un courant induit global de circuler dans un même sens dans les spires de la première partie d'antenne et dans les spires de la deuxième partie d'antenne.

L'invention offre ainsi une carte à puce métallique performantes (de type RFID par exemple) et de fabrication simple, capable de coopérer efficacement en sans contact avec un terminal externe, et ce quelle que soit l'orientation de la carte vis-à-vis du terminal externe.

Lorsque la carte à puce est soumis à un champ magnétique, l'action combinée du courant image acheminé depuis la première partie d'antenne d'une part, et d'un courant induit dans la deuxième partie d'antenne par le champ magnétique au niveau de la zone d'évidemment d'autre part, permet de maximiser la quantité d'énergie collectée dans la deuxième antenne RF à partir du champ magnétique, et donc de garantir un couplage magnétique performant entre les deux antennes RF, ce qui permet de délivrer un maximum d'énergie à la puce RF reliée à la première antenne RF.

En fonctionnement, sous l'effet du champ magnétique auquel est soumise la carte à puce, la puce RF est ainsi capable d'utiliser la deuxième antenne RF couplée avec la première antenne RF pour communiquer avec un terminal externe (en particulier pour échanger des signaux RF en transmission et/ou réception avec le terminal). Lorsqu'un utilisateur présente la carte à puce au voisinage du terminal, une communication sans contact peut ainsi être établie entre le terminal et la carte à puce, et ce quelle que soit l'orientation de cette dernière vis-à-vis du terminal. En effet, des courants de Foucault sont générés dans la couche métallique quelle que soit l'orientation de la carte à puce relativement au terminal. De même, quelle que soit la face de la carte à puce qui est présentée devant le terminal, la deuxième partie d'antenne de la deuxième antenne est capable de collecter une composante de courant induite par le champ magnétique au niveau de la zone d'évidemment.

Selon un mode de réalisation particulier, lesdits courants de Foucault sont produits sous l'effet d'un champ magnétique auquel est soumise la carte à puce.

Selon un mode de réalisation particulier, la deuxième antenne RF est configurée de sorte que la première partie d'antenne s'étend en regard d'une zone périphérique de la couche métallique.

Selon un mode de réalisation particulier, la deuxième antenne RF est configurée de sorte que la deuxième partie d'antenne s'étend exclusivement en regard de la zone d'évidement.

Selon un mode de réalisation particulier, la première antenne RF est disposée en regard de la zone d'évidement de sorte que la zone d'évidement est intercalée entre les première et deuxième antennes RF pour permettre un couplage magnétique entre lesdites première et deuxième antennes.

Selon un mode de réalisation particulier, la deuxième antenne RF est isolée électriquement de la couche métallique et de la première antenne RF par une couche isolante intercalée entre la deuxième antenne RF d'une part, et la couche métallique et la zone d'évidement d'autre part.

Selon un mode de réalisation particulier, la carte à puce comprend en outre un module électronique comportant la puce RF, ledit module électronique étant ménagé dans ou en regard de la zone d'évidement.

Selon un mode de réalisation particulier, les première et deuxièmes parties d'antenne de la deuxième antenne RF sont connectées en parallèle avec un composant capacitif.

Selon un mode de réalisation particulier, le couplage magnétique permet à la puce RF d'établir une communication sans contact avec l'extérieur de la carte à puce en utilisant la deuxième antenne RF couplée à la première antenne RF.

L'invention vise également un procédé de fabrication de la carte à puce telle que définie ci-avant et décrite ci-après dans des modes de réalisation particuliers. Plus précisément, l'invention vise en particulier un procédé de fabrication d'une carte à puce à partir d'un corps de carte formé au moins en partie par une couche métallique, ladite couche métallique comprenant une zone d'évidement débouchant sur un bord périphérique de la couche métallique, ladite couche métallique comprenant une fente connectant la zone d'évidemment au bord périphérique de la couche métallique, le procédé comprenant :
- formation sur ou dans le corps de carte d'une première antenne RF dans ou en regard de la zone d'évidement de la couche métallique ;
- assemblage d'une puce RF avec le corps de carte de sorte que la puce RF est connectée électriquement à la première antenne RF ; et
- formation sur ou dans le corps de carte d'une deuxième antenne RF de sorte que la deuxième antenne RF est isolée électriquement de la couche métallique et de la première antenne RF, la deuxième antenne RF comprenant :
   ∘ une première partie d'antenne s'étendant en regard de la couche métallique pour collecter un courant image induit par des premiers courants de Foucault circulant dans la couche métallique ; et
   ∘ une deuxième partie d'antenne, connectée électriquement à la première partie d'antenne, et s'étendant en regard de la zone d'évidement pour permettre un couplage magnétique entre la première antenne RF et la deuxième antenne RF, les première partie d'antenne (AT2a) et deuxième partie d'antenne (AT2b) comprenant des spires de sorte qu'un courant induit global circule dans un même sens dans les spires de la première partie d'antenne AT2a et dans les spires de la deuxième partie d'antenne AT2b.

On notera que les différents modes de réalisation mentionnés dans ce document en relation avec la carte à puce de l'invention ainsi que les avantages associés s'appliquent de façon analogue au procédé de fabrication de l'invention.

### Brève description des dessins

D'autres caractéristiques et avantages de la présente invention ressortiront de la description faite ci-dessous, en référence aux dessins annexés qui en illustrent des exemples de réalisation dépourvus de tout caractère limitatif. Sur les figures:
[Fig. 1] La figure 1 représente schématiquement une carte à puce coopérant avec un terminal, selon au moins un mode de réalisation de l'invention;
[Fig. 2] La figure 2 est une vue de dessus (ou dessous) d'une couche métallique constituant une partie d'une carte à puce selon au moins un mode de réalisation particulier ;
[Fig. 3] La figure 3 est une vue de dessus (ou dessous) d'une couche métallique constituant une partie d'une carte à puce selon au moins un mode de réalisation particulier ;
[Fig. 4] La figure 4 est une vue éclatée en coupe représentant schématiquement la structure d'une carte à puce selon au moins un mode de réalisation de l'invention ;
[Fig. 5] La figure 5 est une vue de détail en coupe d'une carte à puce, et plus particulièrement d'une portion de la carte comprenant une zone d'évidement, selon au moins un mode de réalisation particulier ;
[Fig. 6] La figure 6 est une vue de dessous représentant schématiquement une carte à puce selon au moins un mode de réalisation particulier ;
[Fig. 7] La figure 7 est une vue de dessous représentant schématiquement le fonctionnement d'une carte à puce selon au moins un mode de réalisation particulier ;
[Fig. 8] La figure 8 est une vue de dessous représentant schématiquement le fonctionnement d'une carte à puce selon au moins un mode de réalisation particulier ; et
[Fig. 9] La figure 9 représente sous forme d'un diagramme les étapes d'un procédé de fabrication d'une carte à puce de l'invention, selon au moins un mode de réalisation particulier.

### Description des modes de réalisation

Comme indiqué précédemment, l'invention porte sur des cartes à puce métalliques configurées pour fonctionner en mode sans contact, et concerne également la fabrication de telles cartes à puce. Une « carte à puce métallique » désigne dans le présent document une carte à puce comprenant un métal ou une combinaison (alliage) de métaux, par exemple sous la forme d'une couche métallique ou d'une pluralité de couches métalliques.

Comme indiqué précédemment, une carte à puce sans contact est configurée par nature pour communiquer en sans contact avec l'extérieur, plus particulièrement avec un terminal externe. A cet effet, une carte à puce sans contact embarque une antenne radiofréquence (RF) pour échanger (recevoir et/ou émettre) des signaux RF avec un terminal externe. Une telle carte à puce peut en outre avoir la capacité de fonctionner aussi en mode avec contact, en utilisant des contacts externes prévus à cet effet à la surface de la carte : on parle alors de cartes « dual » (ou cartes à double interface de communication), ces cartes étant ainsi capable de fonctionner en mode sans contact et en mode avec contact.

Il existe aujourd'hui une forte demande chez les utilisateurs pour des cartes à puce métalliques, pour notamment les raisons évoquées précédemment (aspects esthétiques, impression de qualité, prestige...). Il est en particulier souhaitable de produire des cartes à puce dont l'essentiel (ou une part importante) du corps de carte est en métal, ou du moins dont le corps de carte comporte une plaque métallique (ou couche métallique), afin d'obtenir une certaine uniformité et qualité dans l'aspect visuel et esthétique de la carte.

Or, lorsqu'une carte à puce sans contact comporte une couche métallique ainsi qu'une antenne RF disposée sur l'une des faces de la couche métallique, il a été observé que cette couche métallique perturbe les communications sans contact entre l'antenne RF et l'extérieur, en particulier lorsque la couche métallique est disposée entre l'antenne RF et le terminal externe avec lequel la carte à puce tente de communiquer, en raison du blindage électromagnétique induit par la couche métallique. Ainsi, selon l'orientation de la carte, il peut être possible ou non d'effectuer une transaction sans contact entre une carte à puce métallique et un terminal externe. Dans certains cas, une transaction est possible si l'on présente la carte à puce de sorte que l'antenne soit disposée du côté du terminal (sans que la couche métallique s'interpose entre les deux), mais les communications RF sont perturbées, voire impossibles, si la couche métallique forme une barrière électromagnétique entre l'antenne RF de la carte et le terminal (la plaque métallique fait office de barrière électromagnétique entre la puce RF et le terminal). Toutefois, pour que des communications RF puissent être réalisées entre une carte à puce métallique et un terminal externe, il est généralement nécessaire que la carte comprenne de la ferrite afin de limiter les perturbations électromagnétiques résultant de la partie métallique. Sans ferrite, même en orientant correctement une carte à puce métallique relativement à un terminal externe, il n'est généralement pas possible d'échanger convenablement des communications RF entre la carte et le terminal, rendant de ce fait toute transaction impossible (ou tout du moins difficile).

L'invention se propose de pallier notamment les inconvénients et problèmes mentionnés ci-avant. Pour ce faire, l'invention vise une carte à puce comprenant une couche métallique et une structure d'antenne particulière comprenant deux antennes RF, à savoir une première antenne RF connectée électriquement à une puce RF de la carte, et une deuxième antenne RF s'étendant en partie en regard de la couche métallique pour collecter un courant image induit par des courants de Foucault circulant dans la couche métallique. Une partie de la deuxième antenne RF est en outre configurée pour permettre un couplage magnétique entre la première antenne RF et la deuxième antenne RF. Pour ce faire, la couche métallique comprend une zone d'évidemment, la première antenne RF étant positionnée dans ou en regard de cette zone d'évidemment, et une partie de la deuxième antenne RF est positionnée en regard de la zone d'évidemment pour permettre l'établissement du couplage magnétique entre les deux antennes RF. En établissant un tel couplage au travers de la zone d'évidemment, la puce RF de la carte peut ainsi utiliser la deuxième antenne RF pour communiquer en sans contact avec l'extérieur. Une fente peut en outre être ménagée dans la couche métallique entre la zone d'évidemment et un bord périphérique de ladite couche métallique afin de faciliter le couplage magnétique entre les deux antennes RF.

Ainsi, selon des modes de réalisation particuliers, l'invention prévoit une carte à puce comprenant : un corps de carte formé au moins en partie par une couche métallique, ladite couche métallique comprenant une zone d'évidement débouchant sur un bord périphérique de la couche métallique ; une puce RF ; une première antenne RF disposée dans ou en regard de la zone d'évidement, ladite première antenne RF étant connectée électriquement à la puce RF ; et une deuxième antenne RF isolée électriquement de la couche métallique et de la première antenne RF. La deuxième antenne RF comprend : une première partie d'antenne comprenant s'étendant en regard de la couche métallique pour collecter un courant image induit par des premiers courants de Foucault circulant dans la couche métallique ; et une deuxième partie d'antenne connectée électriquement à la première partie d'antenne, et s'étendant en regard de la zone d'évidement pour permettre un couplage magnétique (c'est-à-dire par induction magnétique) entre la première antenne RF et la deuxième antenne RF.

L'invention concerne également un procédé de fabrication de telles cartes à puce. Des modes de réalisation particuliers, ainsi que d'autres aspects de l'invention, sont décrits plus en détail ci-après.

Dans le présent exposé, des exemples de mises en oeuvre de l'invention sont décrits en relation avec une carte à puce de type « dual », c'est-à-dire une carte à double interface de communication, ayant la capacité de communiquer aussi bien en mode avec contact (via des contacts externes) qu'en mode sans contact (via une structure d'antenne RF). On notera toutefois que l'invention peut s'appliquer plus généralement à une quelconque carte à puce configurée pour communiquer en sans contact, et ce qu'elle est la capacité ou non de fonctionner aussi en mode avec contact.

De plus, on considère dans les exemples qui suivent que la carte à puce est une carte bancaire, telle qu'une carte de paiement par exemple. Cette carte à puce peut être conforme à la norme ISO 7816 et peut fonctionner selon le standard EMV, bien que ni l'un ni l'autre de ces aspects ne soit obligatoire pour mettre en oeuvre l'invention. Plus généralement, l'invention s'applique à une quelconque carte à puce métallique configurée pour mettre en oeuvre une transaction en mode sans contact, y compris des cartes EMV ou des cartes à puce utilisant un autre standard de transaction, par exemple le standard NFC (selon par exemple ISO14443-2 , ISO 10373-6, « EMV Contactless Certification »). De façon générale, la carte à puce de l'invention peut être configurée pour réaliser une transaction d'un type quelconque, telle que des transactions bancaires (transactions de paiement, de transfert, de débit...), des transactions d'authentification, etc.

Sauf indications contraires, les éléments communs ou analogues à plusieurs figures portent les mêmes signes de référence et présentent des caractéristiques identiques ou analogues, de sorte que ces éléments communs ou analogues ne sont généralement pas à nouveau décrits par souci de simplicité.

Les termes « premier(s) » (ou première(s)), « deuxième(s) », etc. sont utilisés dans ce document par convention arbitraire pour permettre d'identifier et de distinguer différents éléments (tels que des clés, des dispositifs, etc.) mis en oeuvre dans les modes de réalisation décrits ci-après.

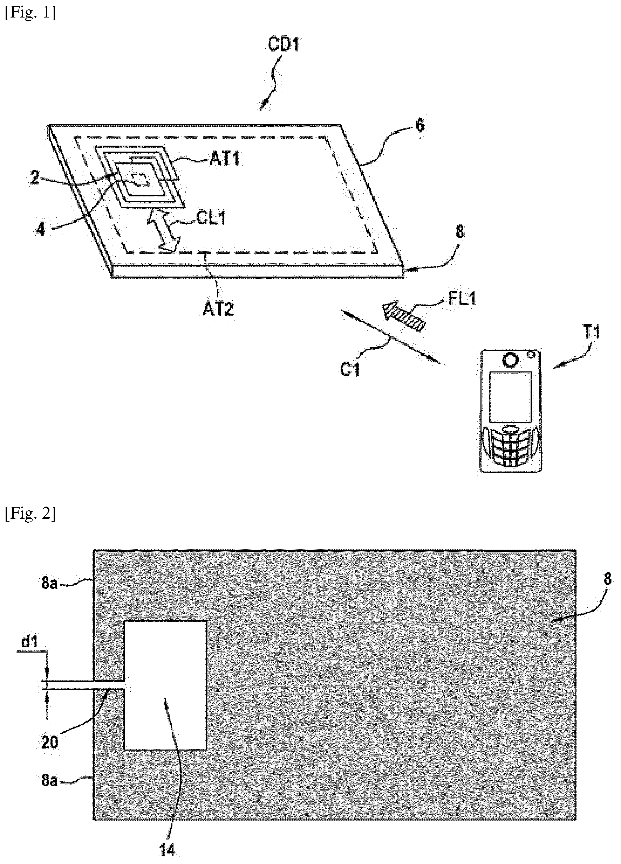

Des modes de réalisation particuliers d'une carte à puce CD1 de l'invention sont à présent décrits en référence aux **figures 1-6****.**

Comme représenté en **figures 1** selon certains modes de réalisation particuliers, la carte à puce CD1 métallique est configurée pour communiquer en mode sans contact avec l'extérieur, par exemple avec un terminal (ou lecteur) externe T1. A cette fin, la carte à puce CD1 comprend une puce RF 4, un corps de carte 6 et deux antennes RF (ou au moins deux antennes RF), à savoir une première antenne RF AT1 et une deuxième antenne RF AT2. La puce RF 4 ainsi que les deux antennes RF AT1 et AT2 sont positionnées sur ou dans le corps de carte 6.

Le corps de carte 6 est formé au moins en partie (ou comprend) une couche métallique 8. Cette couche métallique 8 peut être constituée d'un seul métal, tel que de l'acier inox ou de l'aluminium par exemple, ou d'un alliage de plusieurs métaux différents. La couche métallique 8 peut comprendre une pluralité de sous-couches métalliques. Selon un exemple particulier, le corps de carte 6, et plus généralement la carte à puce CD1 est dépourvue de ferrite, ce qui permet de simplifier la fabrication de la carte.

Dans les exemples considérés ici, le corps de carte 6 est au format ID1 d'une carte de crédit, bien que d'autres formes soient possibles pour mettre en oeuvre l'invention.

La puce RF 4 est une puce une puce électronique configurée pour établir une communication sans contact C1 avec le terminal externe T1 en utilisant les antennes RF AT1 et AT2, comme décrit ci-après. Pour ce faire, la puce RF 4 est connectée électroniquement à la première antenne RF AT1 mais la deuxième antenne RF AT2 est isolée électriquement de la puce RF 4 et de la première antenne RF AT1. Les antennes AT1 et AT2 sont en partie en regard l'une de l'autre pour permettre un couplage magnétique entre ces deux antennes et ainsi permettre à la puce RF 4 d'utiliser la deuxième antenne RF AT2 pour établir une communication sans contact C1 avec le terminal externe T1, comme décrit plus en détail ci-après.

Divers mises en oeuvre de la carte à puce CD1, notamment de la couche métallique 8 et des antennes RF AT1 et AT2, sont possibles, comme représenté en **figures 2-8****.**

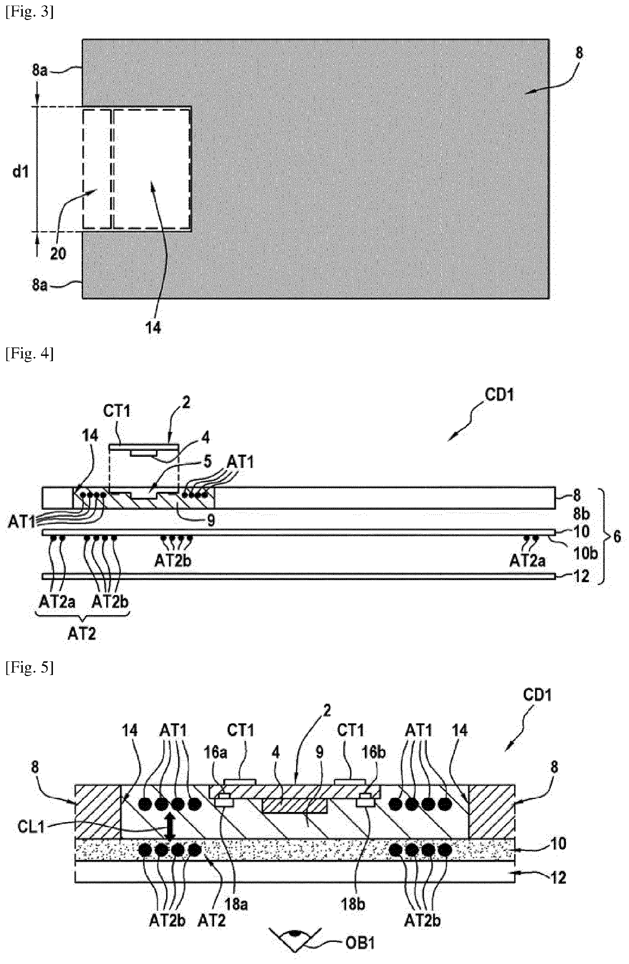

A titre d'illustration, les **figures 2** et **3** représentent seule la couche métallique 8 selon deux modes de réalisation différents. Dans ces deux exemples, la couche métallique 8 comprend une zone d'évidemment 14 débouchant sur un bord (ou contour) périphérique 8a de la couche métallique 8. La zone d'évidemment 14 est une ouverture (ou zone) traversante ménagée dans la couche métallique 8 pour permettre le positionnement en vis-à-vis de la première antenne RF AT1 avec une partie de la deuxième antenne RF AT2 comme décrit ci-après. La forme et les dimensions de cette zone d'évidemment 14 peuvent être adaptées selon le cas. A titre d'exemple, la zone d'évidemment 14 ménagée dans la couche métallique 8 est rectangulaire.

Plus précisément, dans l'exemple représenté en **figure 2**, la couche métallique 8 comprend une ouverture (ou zone) de raccordement 20 qui connecte ou raccorde le bord périphérique 8a avec la zone d'évidemment 14. Cette ouverture de raccordement 20 constitue elle-même une zone d'évidement périphérique qui peut prendre par exemple la forme d'une fente. Autrement dit, la zone d'évidemment 14 émerge (ou débouche) sur le bord périphérique 8a via cette ouverture de raccordement 20. Cette zone de raccordement 20 se caractérise par une distance d1 séparant deux bords périphériques opposés de la couche métallique 8, la valeur de cette distance d1 pouvant varier selon le cas.

Ainsi, selon l'exemple représenté en **figure 3**, la distance d1 de la zone de raccordement 20 séparant deux bords périphériques opposés de la couche métallique 8 est identique à la hauteur (ou longueur) de la zone d'évidemment 14 elle-même. La zone de raccordement 20 forme ainsi dans la couche métallique 8 une deuxième zone d'évidemment qui s'étend dans le prolongement de la première zone d'évidemment 14. La zone d'évidemment 14 forme ainsi avec la zone de raccordement 20 une encoche dans la couche métallique 8. En d'autres termes, la zone d'évidemment 14 s'étend dans cet exemple jusqu'au bord périphérique 8a de la couche métallique 8 (sans que la formation d'une fente ou autre ne soit nécessaire).

La position de la zone d'évidemment 14 dans la couche métallique 8 peut varier selon le cas. Selon les exemples particuliers représentés en **figures 2-3**, la zone d'évidemment 14 positionnée dans le voisinage d'un bord périphérique 8a de la couche métallique 8, ce qui permet d'assurer un couplage magnétique FL1 performant entre les antennes RF AT1 et AT2, comme expliqué plus en détail ci-après. D'autres implémentations sont toutefois possibles, dans lesquelles par exemple la zone d'évidemment 14 est positionné au centre (ou substantiellement au centre) de la couche métallique 8, étant entendu que cette zone d'évidemment 14 est toujours configurée pour débouchée sur (ou être raccordée à) à un bord périphérique 8a de la couche métallique 8 via une zone de raccordement 20.

L'intérêt de former une telle zone d'évidemment 14 dans la couche métallique 8 apparaîtra plus clairement dans la description qui suit. On considère à présent des modes de réalisation particuliers en référence aux **figures 4-7** dans lesquels la couche métallique 8 comprend une zone d'évidemment 14 selon la configuration illustrée en **figure 2****.**

En particulier, la **figure 4** représente schématiquement une vue éclatée en coupe de la carte à puce CD1 et la **figure 5** représente schématiquement une vue de détail en coupe de la carte à puce CD1, selon au moins un mode réalisation particulier.

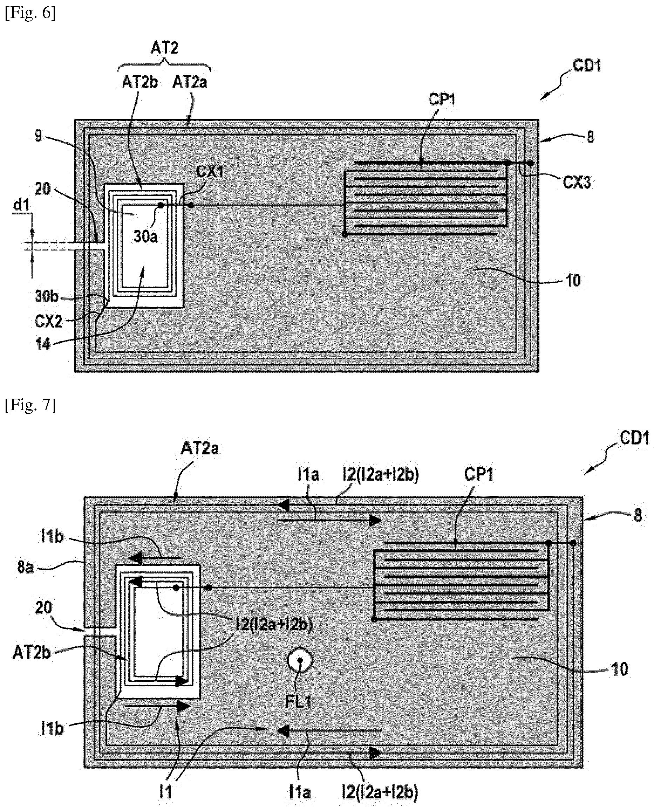

Les **figures 6** et **7** sont des vues de dessous représentant schématiquement la carte à puce CD1 vue depuis sa face inférieure, c'est-à-dire depuis le point de vue d'un observateur OB1 représenté en **figure 5**, de sorte à pouvoir visualiser notamment la deuxième antenne AT2. Pour faciliter la compréhension des figures, ni la première antenne RF AT1 ni le module électronique 2 ne sont représentés en **figures 6-7****.**

La **figure 7** illustre plus particulièrement la carte à puce CD1 en fonctionnement, comme décrit ultérieurement.

Comme représenté en **figures 4-7**, on considère que la puce RF 4 est comprise (ou embarquée) dans un module électronique 2, ce dernier étant inséré dans le corps de carte 6. Le module électronique 2 est par exemple positionné dans une cavité 5 ménagée sur la face supérieure du corps de carte 6. Pour ce faire, la zone d'évidemment 14 comprend un matériau électriquement isolant 9 dans lequel est ménagée la cavité 5 pour accueillir le module électronique 2. Ainsi, la puce RF 4 est positionnée dans la zone d'évidemment 14 (ou, en variante, en regard et au-dessus de la zone d'évidemment 14). A noter toutefois que divers aménagements de la puce RF 4 sont possibles. Des variantes sont notamment possibles dans lesquelles la puce RF 4 n'est pas disposée dans, ou en regard de, la zone d'évidemment 14.

Selon une variante de réalisation, la puce RF 4 (avec ou sans le module électronique 2) est positionnée sur (ou en regard de) la couche métallique 8. A cette fin, un matériau isolant peut être disposé entre la puce RF 4 et la couche métallique pour assurer l'isolation électrique.

Selon les exemples considérés dans les **figures 4-7**, le module électronique 2 comporte sur sa face supérieure des contacts externes (ou plages de contact) CT1 configurés pour permettre une communication par contact entre la puce RF 4 un terminal externe prévu à cet effet (par exemple avec le terminal T1). Plus particulièrement, le module électronique 2 peut comprendre un circuit imprimé (ou PCB pour « Printed Circuit Board ») comprenant sur sa face supérieur les contacts externes CT1 et sur sa face inférieure la puce RF 4. Les contacts externes CR1 sont des zones métalliques conçues pour accueillir des broches de connexion d'un terminal externe. Ces contacts externes CT1 peuvent être conformes à la norme ISO 7816, bien que d'autres exemples soient possibles. Le module électronique 2 est disposé dans la carte à puce CD1 de sorte que ses contacts externes CT1 sont accessibles depuis la surface supérieure du corps de carte 6 pour permettre à la puce RF 4 de communiquer par contact avec un terminal externe.

Comme déjà indiqué, des modes de réalisation sont également possibles sans de tels contacts externes CT1. De plus, l'intégration de la puce RF 4 dans à le module électronique 2 tel que représenté sur les figures n'est pas obligatoire, d'autres aménagements de la puce RF 4 étant possibles sans un tel module.

Comme déjà indiqué en référence à la **figure 1**, la carte à puce CD1 comprend deux antennes RF, notées AT1 et AT2, qui sont positionnées dans ou sur le corps de carte 8. Chacune des antennes RF AT1, AT2 comprend au moins une spire électriquement conductrice de sorte à permettre des échanges de signaux RF entre la carte à puce CD1 et l'extérieur.

Les antennes RF AT1 et AT2 peuvent chacune être constituées par exemple d'une piste, fil ou membre électriquement conducteur formant une ou des spires conductrices. On considère dans le cas présent que les première et deuxième antennes RF AT1, AT2 comprennent chacune une pluralité de spires conductrices. Diverses techniques de fabrication (filaire, par dépôt, par gravure) bien connues en soi peuvent être utilisées pour réaliser ces antennes RF. Les caractéristiques physiques (forme/taille de l'intersection, longueur de l'antenne, nombre de spire, matériau, etc.) des antennes RF AT1 et AT2 peuvent être adaptées au cas par cas afin notamment de permettre des communications sans fil aux fréquences (ou plages de fréquences) souhaitées.

Plus précisément, comme représenté en **figures 4-7**, la première antenne RF AT1 comprend une pluralité de spires électriquement conductrices - dites « premières » spires conductrices - disposées dans la zone d'évidemment 14. Dans ce cas particulier, la taille de de l'antenne RF AT1 est donc limitée dans la mesure où ses premières spires conductrices sont contenues dans la zone d'évidemment. En variante, la première antenne RF AT1 peut être disposée, non pas dans la zone d'évidemment 14 elle-même, mais en regard (au-dessus) de cette zone d'évidemment 14.

Par ailleurs, la deuxième antenne RF AT2 est isolée électriquement de la couche métallique 8 et de la première antenne RF AT1. Cette isolation peut être assurée de différentes manières selon le cas. A titre d'exemple, on considère que le corps de carte 6 comprend une couche électriquement isolante 10 (pouvant être appelée couramment « inlay » qui signifie « inner layer » en anglais). La deuxième antenne RF AT2 est ainsi isolée électriquement de la couche métallique 8 et de la première antenne RF AT1 par cette couche isolante 10 qui est intercalée entre la deuxième antenne RF AT2 d'une part, et la couche métallique 8 et la zone d'évidement 14 d'autre part. La couche isolante 10 se trouve en particulier à l'interface entre la deuxième antenne AT2 et le matériau isolant 9 dans lequel s'étend la première antenne RF AT1.

En outre, la deuxième antenne RF AT2 comprend deux parties d'antenne, à savoir une première partie d'antenne AT2a et une deuxième partie d'antenne AT2b, qui sont connectées électriquement l'une à l'autre. Dans cet exemple particulier, cette deuxième antenne RF AT2 est formée dans la couche isolante 10 ou éventuellement sur la face inférieure 10b de la couche isolante 10.

Plus précisément, la première partie d'antenne AT2a comprend une pluralité de spires électriquement conductrices, dites « deuxièmes » spires conductrices, qui s'étendent en regard (ou en vis-à-vis) de la couche métallique 8 pour collecter notamment un courant image I2a induit par des courants de Foucault I1 - appelés par la suite « premiers » courants de Foucault - circulant dans la couche métallique 8. Comme décrit ci-après en référence à la **figure 7**, des courants de Foucault sont produits sous l'effet d'un champ magnétique FL1 auquel est soumise la carte à puce. Un tel champ magnétique est généré dans cet exemple (**figure 1**) par un terminal externe T1 avec lequel la carte à puce CD1 coopère en mode sans contact. Lorsque la carte à puce CD1 est exposé au champ magnétique FL1, des courants de Foucault circulent sous la forme de boucles de courant (boucles primaires et boucles secondaires) en surface de la couche métallique 8 (en particulier sur la face inférieure 8a de la couche métallique 8 dans cet exemple ; **figure 4**)**.** Le phénomène de la formation des courants de Foucault est connu de l'homme du métier et ne sera donc pas décrit en détail dans ce document.

Diverses configurations de la première partie d'antenne AT2a sont possibles pour accomplir la collecte du courant image I2a susmentionné. Comme illustré en **figures 6-7**, on considère dans cet exemple que la première partie d'antenne AT2a (et plus précisément les deuxièmes spires conductrices qui la compose) s'étend en regard d'une zone périphérique de la couche métallique 8 (c'est-à-dire au voisinage du contour périphérique de la couche métallique 8). Cette zone périphérique encercle la zone d'évidement 14 ménagée dans la couche métallique 8. Cette configuration vise à permettre à la première partie d'antenne AT2a de collecter un maximum d'énergie sous forme de courant image induit I2a par les boucles dominantes des courants de Foucault générées en surface de la couche métallique 8 sous l'effet d'un champ magnétique FL1 auquel est soumis la carte à puce CD1. Autrement dit, grâce à cette configuration particulière, les premiers de courants de Foucault I1 (à partir desquels est produit le courant image I2 collecté dans la première partie d'antenne AT2a) correspondent à des boucles dominantes des courants de Foucault circulant dans (ou en surface de) la couche métallique 8 en réponse au champ magnétique FL1. D'autres configurations des deuxièmes spires conductrices de la première partie d'antenne AT2a sont toutefois envisageables.

Ainsi, selon un exemple particulier, la première partie d'antenne AT2a enlace (ou encercle, ou entoure) la deuxième partie AT2b et la première antenne RF AT1. Ainsi, dans le cas par exemple où la carte à puce CD1 présente un format de carte bancaire classique (format ID1), la première partie d'antenne AT2a peut être disposée le long du contour périphérique de la couche métallique 8 (de préférence au plus près du bord physique de la couche métallique 8), tout en adoptant cette configuration spatiale d'enlacement. L'écart entre la première partie d'antenne AT2a et le bord périphérique de la couche métallique 8 peut être supérieur ou égal à un écart minimal qui dépend de la technologie d'antenne utilisée (par exemple, l'écart minimal est fixé à environ 500 µm si la première partie d'antenne AT2a est fabriquée selon une technique dite PCB pour « Printed Card Board », ou fixé à environ 2 mm, voire à environ 3 mm si la première partie d'antenne AT2a est de fabriquée selon une technologie filaire (type filaire). L'écart maximum entre la première partie d'antenne AT2a et le bord périphérique de la couche métallique 8 peut par ailleurs est adapté au cas par cas, dans la mesure où la première partie d'antenne AT2a enlace la deuxième partie AT2b et la première antenne RF AT1.

Selon un exemple particulier, le corps de carte 6 est au format ID1 d'une carte de crédit et la première partie d'antenne AT2a comprend des deuxièmes spires conductrices qui sont également substantiellement au format ID1.

Par ailleurs, la deuxième partie d'antenne AT2b comprend une pluralité de spires électriquement conductrices, dites « troisièmes » spires conductrices. La deuxième partie d'antenne AT2b est connectée électriquement à la première partie d'antenne AT2a et s'étend en regard de la zone d'évidement 14 pour permettre un couplage CL1 (**figure 5**) par induction magnétique (couplage magnétique) entre la première antenne RF AT1 et la deuxième antenne RF AT2.

En effet, la couche métallique 8 s'étend dans le corps de carte 6 de sorte à former un blindage électromagnétique (ou barrière électromagnétique) entre les deux faces de la carte à puce DV1. Ainsi, la deuxième partie d'antenne AT2b est isolée électromagnétiquement par la couche métallique 8 vis-à-vis de la face supérieure de la carte à puce CD1 et de l'environnement extérieur se trouvant au voisinage de cette face supérieure. A l'exception de la première antenne RF AT1 pouvant le cas échéant être disposée dans la zone d'évidemment 14, cette zone d'évidemment 14 est dépourvue de matériau électriquement conducteur, ce qui permet à la deuxième partie d'antenne AT2b de se coupler électromagnétiquement avec la première antenne RF AT1 au travers de ladite zone d'évidemment 14 (**figure 5**), sans que la couche métallique 8 ne puisse y faire obstacle. Cela permet également un couplage d'énergie direct à partir du champ magnétique incident du terminal T1 et la deuxième partie d'antenne AT2b, ce qui génère une composante de courant I2b comme décrit ci-après en référence notamment aux **figures 7-8****.**

Pour établir un couplage magnétique CL1 performant, la deuxième partie d'antenne AT2b est de préférence positionnée en regard, au moins en partie, de la première antenne RF AT1. De façon générale, la deuxième partie d'antenne AT2b est tout du moins alignée avec, ou en regard de, la zone d'évidemment 14 de sorte à ce que le couplage magnétique CL1 puisse être établi. Un décalage peut toutefois être toléré entre les premières spires de la première antenne RF AT1 et les troisièmes spires de la deuxième partie d'antenne AT2b dans la mesure où la zone d'évidemment 9 permet malgré tout d'assurer le couplage magnétique CL1.

Une fois le couplage magnétique CL1 établi entre les antennes RF AT1 et AT2 sous l'effet d'un champ magnétique FL1 auquel est soumise la carte à puce CD1, la puce RF 4 peut ainsi utiliser la deuxième antenne RF AT2, couplée à la première antenne RF AT1, pour communiquer en mode sans contact avec l'extérieur, à savoir avec le terminal externe T1 dans cet exemple (**figure 1**). Le fonctionnement de la carte à puce CD1 et en particulier de ses antennes RF est décrit plus en détail ultérieurement.

La puce RF 4 peut comprendre par exemple un microcontrôleur (ou un processeur) configuré pour établir une communication sans contact C1 avec l'extérieur de la carte à puce CD1 (avec le terminal externe T1 dans cet exemple) en utilisant les première et deuxième antennes RF AT1, AT2 couplées ensemble par induction magnétique.

De manière générale, la première partie d'antenne AT2a de la deuxième antenne RF AT2 occupe une surface plus importante que la deuxième partie d'antenne AT2b puisque cette dernière est positionnée en regard de la zone d'évidement 14.

Comme déjà indiqué, la puce RF 4 est disposée dans la zone d'évidemment 14 dans l'exemple représenté en **figures 4-7****.** Selon une variante, la première antenne RF AT1 est disposée hors de la zone d'évidemment 14, à savoir en regard de la zone d'évidement 14 (en alignement au-dessus de celle-ci), de sorte que la zone d'évidement 14 est intercalée entre les première et deuxième antennes RF AT1 et AT2 pour permettre un couplage CL1 par induction magnétique entre lesdites première et deuxième antennes AT1 et AT2. Comme représenté en **figures 4-5****,** la puce RF 4 est connectée électriquement à la première antenne RF AT1. Dans l'exemple considéré ici, la connexion électrique est assurée via des plots (ou plages) de connexion 16a et 16b dont est équipés le module électronique 2, ces plots étant connectés respectivement à des plots (ou plages) de connexion 18a et 18b prévues à cet effet dans la zone d'évidemment 14 (dans le matériau isolant 9 dans cet exemple). Les plots de connexion 18a et 18b sont à leur tour connectés respectivement aux deux extrémités de la première antenne RF AT1. D'autres manières de connecter la puce RF 4 avec la première antenne RF AT1 sont toutefois envisageables.

Diverses configurations de la deuxième antenne RF AT2 sont possibles. Selon un mode de réalisation préféré, la deuxième partie d'antenne AT2b s'étend exclusivement en regard de la zone d'évidement 14. Autrement dit, cette deuxième partie d'antenne AT2b, formée d'une pluralité de troisièmes spires conductrices, est disposée en regard de la zone d'évidement 14 de sorte à ce qu'elle ne s'étend pas en regard de la couche métallique 8. En particulier, la deuxième partie d'antenne AT2b ne se superpose pas (ou ne recouvre pas) la couche métallique 8 en périphérie de la zone d'évidemment 14, ce qui permet d'optimiser le flux du champ magnétique auquel est soumis la deuxième partie d'antenne AT2b ainsi que la première antenne RF AT1. Bien qu'il ne soit pas souhaitable qu'une portion de la deuxième partie d'antenne AT2b s'étende en regard de la couche métallique 8, une certaine tolérance peut être acceptée dans certains cas.

Comme représenté en **figures 1**, **4** et **5**, la puce RF 4 (et éventuellement le module électronique 2) peut être alignée ou centrée vis-à-vis de la zone d'évidemment 4. Ainsi, dans les exemples considérés, les spires conductrices de la première antenne RF AT1 s'étendent sous la forme d'un enroulement autour de la puce RF 4 dans la zone d'évidemment 14. Cet arrangement permet de positionner la puce RF 4 au plus proche de la première antenne RF AT1 et ainsi de limiter la complexité de fabrication de la carte à puce CD1. Comme déjà indiqué, d'autres mises en oeuvre sont toutefois possibles où la puce RF 4 n'est pas positionnée dans, ni même en regard de, la zone d'évidemment 14.

La puce RF 4, et plus généralement le module électronique 2, peuvent être aménagés dans la couche isolante 9 (appelé couramment « inlay »). Cette configuration permet de faciliter le montage de la puce RF 4 et de la première antenne RF AT1 dans le corps de carte 6.

Comme représenté en **figure 6**, la carte à puce CD1 peut en outre comprendre un composant capacitif CP1 connecté électriquement à la deuxième antenne RF AT2. Dans les exemples considérés ici, le composant capacitif CP1 est disposé dans la couche isolante 10 ou sur la face inférieure 10b de cette couche isolante 10. Une fois le couplage magnétique CL1 établi, les antennes RF AT1 et AT2 sont connectées en parallèle avec le composant capacité CP1. Ce composant capacitif CP1 forme ainsi avec les antennes RF AT1 et AT2 un circuit RLC permettant d'adapter la fréquence de résonnance de la deuxième antenne RF AT2 de sorte à ce qu'elle soit par exemple égale à 13,56 MHz, ce qui permet une communication C1 en mode sans contact de type RFID avec un lecteur T1 RFID (par exemple selon la norme ISO14443/ ISO 10373, notamment la version actuelle ISO/IEC 10373-6:2020 ou l'une quelconque des versions antérieures, ou une quelconque version ultérieure).

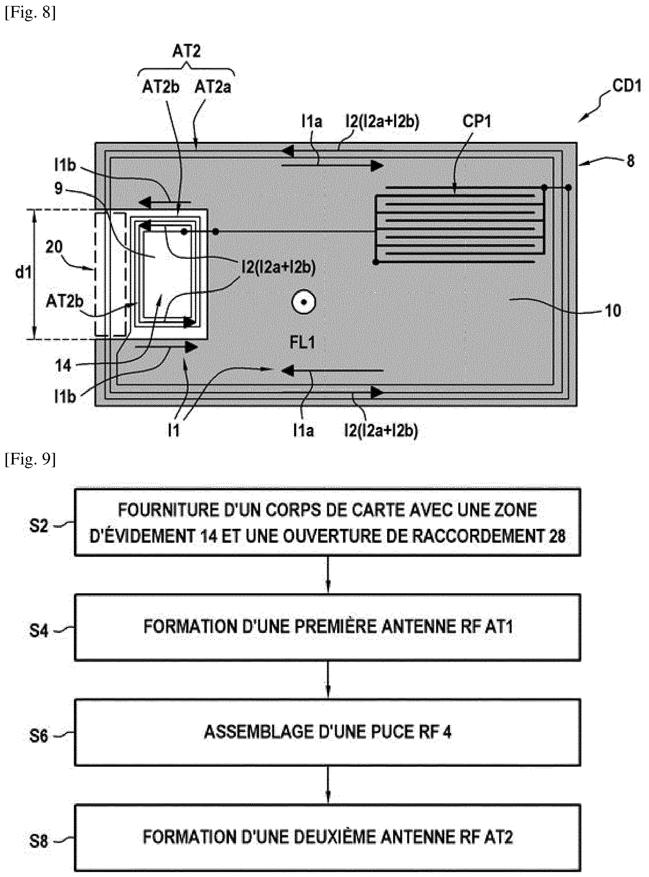

Dans les exemples représentés en **figures 6-7**, le composant capacitif CP1 est de type interdigital et comprend deux jeux opposés de doigts conducteurs entremêlés les uns avec les autres, d'autres formes de condensateur étant toutefois possibles (condensateur à plaques parallèles, condensateur discret monté en surface, condensateur à fils parallèles, etc.). A noter que la capacité « interdigitée » CP1 (avec entremêlement de doigts conducteurs disposées en face à face) est représentée de façon schématique dans les **figures 6-7** (et en **figure 8** décrite ci-après) et ne constitue pas nécessairement la mise en oeuvre la plus adaptée de la capacitance CP1 dans la carte à puce CD1. L'on pourrait préférer par exemple la réalisation de la capacitance CP1 sous la forme d'une capacité à plaques parallèles de part et d'autre de la couche isolante 10 ou d'une capacité discrète de type « CMS » (pour « composant monté en surface »).

Comme représenté en **figures 6-7**, on considère par exemple qu'une première extrémité 30a de la deuxième partie d'antenne AT2b est connectée via une première connexion CX1 avec le composant capacitif CP1 et qu'une deuxième extrémité 30b de la deuxième partie d'antenne AT2b est connectée via une deuxième connexion CX2 avec une première extrémité de la première partie d'antenne AT2a. Par ailleurs, le composant capacitif CP1 est connecté via une troisième connexion CX3 avec une deuxième extrémité de la première partie d'antenne AT2a.

La puce RF 4 est ainsi configurée pour communiquer en sans contact en utilisant la deuxième antenne RF AT2 lorsque cette dernière est couplée magnétiquement avec la première antenne RF AT1. En outre, la puce RF 4 peut le cas échéant communiquer en mode par contact avec l'extérieur via les contacts externes CT1, bien que des variantes sans de tels contacts externes soient possibles.

Comme représenté en **figures 4-7**, le corps de carte 6 peut en outre comprendre au moins une couche isolante externe 12 ménagée sur la face inférieure 10b de la couche isolante 10 de sorte à recouvrir et protéger la deuxième antenne RF AT2. Les première et deuxième parties d'antenne AT2a et AT2b se trouvent ainsi intercalées entre la couche isolante interne 10 et la couche isolante externe 12 dans cet exemple particulier. Au moins une couche isolante de protection peut également être ménagée si besoin sur la face supérieure du corps de carte.

La carte à puce CD1 telle que décrite précédemment en référence aux **figures 1-2** et **4-6** est à présente décrite en cours de fonctionnement en référence à la **figure 7**, selon au moins un mode de réalisation particulier. On considère toujours ici que la couche métallique 8 présente une configuration telle qu'illustrée en **figure 2** bien que des variantes soient possibles.

On suppose que la carte à puce CD1 est positionnée à portée de (dans le voisinage du) terminal externe T1 de sorte à être exposée au champ magnétique FL1 émanant du terminal T1. Sous l'effet du champ magnétique FL1 auquel est soumise la carte à puce CD1, des courants de Foucault - notés généralement I1 - sont générés dans la couche métallique 8. Ces courants de Foucault I1 circulent sous forme de boucles de courant en surface de la couche métallique 8. Selon un phénomène physique bien connu, des boucles dominantes et des boucles secondaires, de courant de Foucault, sont ainsi générées en surface de la couche métallique 8 en réaction au champ magnétique FL1.

Comme représenté en **figure 7**, on note I1a des courants de Foucault - dits premiers courants de Foucault - correspondant à des boucles dominantes circulant en surface de la couche métallique 8 au voisinage du contour périphérique de ladite couche métalliques 8. On note I1b des courants de Foucault - dits deuxièmes courants de Foucault - correspondant à des boucles secondaires circulant en surface de la couche métallique 8 au voisinage du contour périphérique de la zone d'évidemment 14. Puisque les courants de Foucault circulent en boucles fermées, les courants de Foucault I1b sont en réalité la continuité des courants de Foucault I1a au voisinage du contour périphérique de la zone d'évidement 14. Comme cela apparaît de la **figure 7**, les deuxièmes courants de Foucault I1b circulent, au voisinage de la deuxième partie d'antenne AT2b, dans un sens de rotation (ou sens de circulation) opposé à celui des premiers courants de Foucault I1a circulant au voisinage du contour périphérique de la couche métallique 8. A titre d'exemple, on considère dans cet exemple que les premiers et deuxièmes courants de Foucault I1a, I1b circulent selon respectivement les sens horaire et antihoraire, une configuration inverse étant toutefois possible selon l'orientation du champ magnétique FL1 considéré. La circulation en sens opposé des courants de Foucault I1a et I1b résulte en particulier de la continuité des courants de Foucault mentionnée ci-avant, ainsi que de la présence de la zone d'évidemment 14 qui est reliée dans cet exemple par la fente de raccordement 20 au contour périphérique 8a de la couche métallique 8.

Comme expliqué plus en détail ci-après, le courant I2 circulant dans la deuxième antenne RF AT2 est un courant induit résultant de deux composantes, à savoir : un courant image I2a induit par les premiers courants de Foucault I1 circulant en surface de la couche métallique 8 au voisinage de la première partie d'antenne AT2a ; et un courant I2b qui est induit directement dans la deuxième partie d'antenne AT2b par le champ magnétique incident FL1 au travers de la zone d'évidemment 14 (12 = I2a + I2b). La structure même de la carte à puce CD1 est conçue pour conduire à cette double contribution des courants induits I2a et I2b pour collecter dans la deuxième antenne RF un courant induit global I2 le plus important possible.

Plus précisément, la première partie d'antenne AT2a s'étendant en regard de la couche métallique 8 collecte un courant image I2a induit par les premiers courants de Foucault I1a circulant en surface de la couche métallique 8 sous l'effet du champ magnétique FL1 (**figure 7**)**.** Ces premiers courants de Foucault I1a correspondent à des boucles dominantes circulant en surface de la couche métallique 8 au voisinage des spires de la première partie d'antenne AT2a. Comme déjà indiqué, la première partie d'antenne AT2a peut s'étendre de préférence en regard d'une zone (ou bande) périphérique de la couche métallique 8 pour collecter un maximum d'énergie généré par les boucles dominantes des courants de Foucault. Les premiers courants de Foucault I1a circulant dans le voisinage de la première partie d'antenne AT1a (dans cet exemple en périphérie de la couche métallique 8) produisent un effet qui s'oppose au champ magnétique incident FL1. Le courant induit I2a collecté dans les spires de la première partie d'antenne AT2a est lui-même un effet de réaction aux premiers courants de Foucault I1a.

Ainsi, le courant image I2a induit par les premiers courants de Foucault I1a est acheminé par conduction électrique jusqu'à la deuxième partie d'antenne AT2b, du fait de la continuité électrique entre les première et deuxième parties d'antenne AT2a, AT2b qui sont connectées ensemble. Le courant image I2a circule ainsi dans les spires de la deuxième partie d'antenne AT2b positionnée en regard de la zone d'évidemment 14. Comme illustré en **figure 7**, le courant image I2a circule selon le même sens de rotation (ou même sens de circulation) dans les spires de la première partie d'antenne AT2a et dans celles de la deuxième partie d'antenne AT2b, à savoir selon le sens antihoraire dans cet exemple. Cependant, du fait de la présence dans la couche métallique 8 de la zone d'évidemment 14 connectée via la fente de raccordement 20 au bord périphérique 8a, les deuxièmes courants de Foucault I1b (boucles secondaires) circulent au voisinage de la zone d'évidemment 14, en surface de la couche métallique 8, selon un sens de rotation (ou sens de circulation) opposé à celui des premiers courants de Foucault I2a circulant en périphérie de la couche métallique 8. A titre d'exemple, les deuxièmes courants de Foucault I1b circulent ici dans le sens antihoraire tandis que les premiers courants de Foucault I1a circulent suivant le sens horaire. Aussi, les deuxièmes courants de Foucault I1b circulant en périphérie de la zone d'évidemment 4 contribuent à amplifier le courant image I1a circulant dans les spires de la deuxième partie d'antenne AT2b.

Comme déjà indiqué, la deuxième partie d'antenne AT2b collecte en outre dans ses spires un courant I2b qui est induit directement par le champ magnétique incident FL1 capté au niveau de la zone d'évidemment 14 par la deuxième partie d'antenne AT2b. Dans cet exemple, le champ magnétique FL1 est dirigé depuis la face supérieure de la carte à puce CD1 vers sa face inférieure. Aussi, la composante de courant I2b induite dans la deuxième partie d'antenne AT2b circule également dans le sens antihoraire et s'ajoute donc au courant image I2a. Puisque les deux composantes de courant I2a et I2b circulent dans la même direction (composantes en phase) dans la deuxième antenne AT2, elles s'ajoutent pour contribuer ensemble à la génération du courant induit global I2 circulant dans la deuxième antenne AT2.

Le courant global I2 circulant dans la deuxième partie d'antenne AT2b induit à son tour un champ magnétique causant un couplage magnétique CL1 entre la première antenne RF AT1 et la deuxième partie d'antenne RF AT2b, et donc a fortiori entre la première antenne RF AT1 et la deuxième antenne RF AT2. L'action combinée du courant image I2a acheminé depuis la première partie d'antenne AT2a d'une part, et du courant I2b induit par le champ magnétique FL1 au niveau de la zone d'évidemment 14 dans la deuxième partie d'antenne AT2b d'autre part, permet de maximiser la quantité d'énergie collectée dans la deuxième antenne RF AT2 à partir du champ magnétique FL1, et donc de garantir un couplage magnétique CL1 performant entre les deux antennes RF AT1, AT2, ce qui permet de délivrer un maximum d'énergie à la puce RF 4 reliée à la première antenne RF AT1.

En fonctionnement, sous l'effet du champ magnétique FL1 auquel est soumise la carte à puce CD1, la puce RF 4 est ainsi capable d'utiliser la deuxième antenne RF AT2 couplée avec la première antenne RF AT1 pour communiquer avec le terminal externe T1 (en particulier pour échanger des signaux RF en transmission et/ou réception avec le terminal T1). Lorsqu'un utilisateur présente la carte à puce CD1 au voisinage du terminal T1, une communication sans contact peut ainsi être établie entre le terminal T1 et la carte à puce CD1, et ce quelle que soit l'orientation de cette dernière vis-à-vis du terminal T1. En effet, les courants de Foucault I1 (et en particuliers les premiers courants de Foucault I1) sont générés dans la couche métallique 8 quelle que soit l'orientation de la carte à puce CD1 relativement au terminal T1. De même, quelle que soit la face de la carte à puce CD1 qui est présentée devant le terminal T1, la deuxième partie d'antenne AT2b de la deuxième antenne AT2 est capable de collecter la composante de courant I2b induite par le champ magnétique FL1 au niveau de la zone d'évidemment 14.

Comme déjà indiqué, divers arrangements de la carte à puce CD1 peuvent être envisagés, notamment en ce qui concerne la configuration de forme, dimensions, position, etc. de la zone d'évidemment 14 et de l'ouverture de raccordement 20 connectant la zone d'évidemment 14 au bord périphérique 8a de la couche métallique 8 (**figures 2-7**)**.** Ainsi, la **figure 8** est une vue de dessous représentant schématiquement le fonctionnement d'une carte à puce CD1 selon au moins un mode de réalisation particulier, lorsque cette carte est soumise à un champ magnétique FL1 émanant par exemple d'un terminal externe T1 (**figure 1**). Dans l'exemple de la **figure 8**, la couche métallique 8 est configurée comme illustrée en **figure 3**, de sorte que la zone de raccordement 20 forme dans la couche métallique 8 une deuxième zone d'évidemment qui s'étend dans le prolongement de la première zone d'évidemment 14. La zone d'évidemment 14 forme ainsi avec la zone de raccordement 20 une encoche dans la couche métallique 8. En d'autres termes, la zone d'évidemment 14 s'étend dans cet exemple jusqu'au bord périphérique 8a de la couche métallique 8 (sans que la formation d'une fente ou autre ne soit nécessaire).

La description ci-dessus relative à l'arrangement et au fonctionnement de la carte à puce CD1 en référence aux **figures 1-7** s'applique de façon analogue à la carte à puce CD1 de la **figure 8****.**

La **figure 9** représente schématiquement un procédé de fabrication de l'une des cartes à puce CD1 décrites ci-avant, selon au moins un mode de réalisation particulier. La description ci-avant de la carte à puce CD1 selon divers modes de réalisation en référence aux **figures 1-8** s'applique par analogie au procédé de fabrication illustré en **figure 9****.**

Au cours d'une étape S2 de fourniture, on forme (ou fournit) un corps de carte 6 comprenant une couche métallique 8 comme précédemment décrite. En particulier, ce corps de carte 6 est formé au moins en partie par une couche métallique 8, cette couche métallique 8 comprenant une zone d'évidement 14 débouchant sur un bord périphérique 8a de la couche métallique, comme déjà décrit.

Au cours d'une étape S4 de formation, une première antenne RF AT1 est formée (ou assemblée) sur ou dans le corps de carte 6 dans ou en regard de la zone d'évidement 14 de la couche métallique 8, comme déjà décrit.

Au cours d'une étape S6 d'assemblage, une puce RF 4 est assemblée avec le corps de carte 6 de sorte que la puce RF 4 est connectée électriquement à la première antenne RF, comme précédemment décrit.

Au cours d'une étape S8 de formation, une deuxième antenne RF AT2 est formée (ou assemblée) sur ou dans le corps de carte 6 de sorte que la deuxième antenne RF AT2 est isolée électriquement de la couche métallique 8 et de la première antenne RF AT1, comme déjà décrit. En particulier, l'étape S8 de formation est réalisée de sorte que la deuxième antenne RF comprend :
- une première partie d'antenne AT2a s'étendant en regard de la couche métallique pour collecter un courant image I2a induit par des premiers courants de Foucault I1a circulant dans la couche métallique ; et
- une deuxième partie d'antenne AT2b, connectée électriquement à la première partie d'antenne AT2a, et s'étendant en regard de la zone d'évidement pour permettre un couplage FL1 par induction magnétique entre la première antenne RF et la deuxième antenne RF.

Un homme du métier comprendra que les modes de réalisation et variantes décrits ci-avant ne constituent que des exemples non limitatifs de mise en oeuvre de l'invention. En particulier, l'homme du métier pourra envisager une quelconque adaptation ou combinaison des modes de réalisation et variantes décrits ci-avant, afin de répondre à un besoin bien particulier conformément aux revendications présentées ci-après.

## Revendications

1. Carte à puce (CD1) comprenant :
- un corps de carte (6) formé au moins en partie par une couche métallique (8), ladite couche métallique comprenant une zone d'évidement (14) débouchant sur un bord périphérique (8a) de la couche métallique, ladite couche métallique comprenant une fente connectant la zone d'évidemment au bord périphérique de la couche métallique ;
- une puce RF (4) ;
- une première antenne RF (AT1) disposée dans ou en regard de la zone d'évidement, ladite première antenne RF étant connectée électriquement à la puce RF ; et
- une deuxième antenne RF (AT2) comprenant :
∘ une première partie d'antenne (AT2a) s'étendant en regard de la couche métallique pour collecter un courant image (I2a) induit par des premiers courants de Foucault (I1a) circulant dans la couche métallique ; et
∘ une deuxième partie d'antenne (AT2b), connectée électriquement à la première partie d'antenne (AT2a),
les première partie d'antenne (AT2a) et deuxième partie d'antenne (AT2b) comprenant des spires,
**caractérisé en ce que** :
- la deuxième antenne RF (AT2) est isolée électriquement de la couche métallique et de la première antenne RF ;
- la deuxième partie d'antenne (AT2b) s'étend en regard de la zone d'évidement pour permettre un couplage magnétique (CL1) entre la première antenne RF et la deuxième antenne RF, et
- ladite carte à puce permettant à un courant induit global (I2) de circuler dans un même sens dans les spires de la première partie d'antenne AT2a et dans les spires de la deuxième partie d'antenne AT2b.

2. Carte à puce selon la revendication 1, dans laquelle lesdits courants de Foucault sont produits sous l'effet d'un champ magnétique (FL1) auquel est soumise la carte à puce.

3. Carte à puce selon la revendication 1 ou 2, dans laquelle la deuxième antenne RF est configurée de sorte que la première partie d'antenne s'étend en regard d'une zone périphérique de la couche métallique.

4. Carte à puce selon l'une quelconque des revendications 1 à 3, dans laquelle la deuxième antenne RF est configurée de sorte que la deuxième partie d'antenne s'étend exclusivement en regard de la zone d'évidement.

5. Carte à puce selon l'une quelconque des revendications 1 à 4, dans laquelle la première antenne RF (AT1) est disposée en regard de la zone d'évidement de sorte que la zone d'évidement est intercalée entre les première et deuxième antennes RF (AT1, AT2) pour permettre un couplage magnétique entre lesdites première et deuxième antennes.

6. Carte à puce selon l'une quelconque des revendications 1 à 5, dans laquelle la deuxième antenne RF (AT2) est isolée électriquement de la couche métallique et de la première antenne RF par une couche isolante intercalée entre la deuxième antenne RF d'une part, et la couche métallique et la zone d'évidement d'autre part.

7. Carte à puce selon l'une quelconque des revendications 1 à 6, dans laquelle la carte à puce comprend en outre un module électronique comportant la puce RF, ledit module électronique étant ménagé dans ou en regard de la zone d'évidement.

8. Carte à puce selon l'une quelconque des revendications 1 à 7, dans laquelle les première et deuxième parties d'antenne de la deuxième antenne RF sont connectées en parallèle avec un composant capacitif.

9. Carte à puce selon l'une quelconque des revendications 1 à 8, dans laquelle le couplage magnétique permet à la puce RF d'établir une communication sans contact avec l'extérieur de la carte à puce en utilisant la deuxième antenne RF couplée à la première antenne RF.

10. Carte à puce selon l'une quelconque des revendications 1 à 9, ladite carte à puce CD1 étant dépourvue de ferrite.

11. Procédé de fabrication d'une carte à puce (CD1) à partir d'un corps de carte (6) formé au moins en partie par une couche métallique (8), ladite couche métallique comprenant une zone d'évidement (14) débouchant sur un bord périphérique (8a) de la couche métallique, ladite couche métallique comprenant une fente connectant la zone d'évidemment au bord périphérique de la couche métallique, le procédé comprenant :
- formation sur ou dans le corps de carte d'une première antenne RF (AT1) dans ou en regard de la zone d'évidement de la couche métallique ;
- assemblage d'une puce RF (4) avec le corps de carte de sorte que la puce RF (4) est connectée électriquement à la première antenne RF ; et
- formation sur ou dans le corps de carte d'une deuxième antenne RF (AT2) de sorte que la deuxième antenne RF est isolée électriquement de la couche métallique et de la première antenne RF, la deuxième antenne RF comprenant :
∘ une première partie d'antenne (AT2a) s'étendant en regard de la couche métallique pour collecter un courant image (I2a) induit par des premiers courants de Foucault (I1a) circulant dans la couche métallique ; et
∘ une deuxième partie d'antenne (AT2b), connectée électriquement à la première partie d'antenne (AT2a), et s'étendant en regard de la zone d'évidement pour permettre un couplage (FL1) magnétique entre la première antenne RF et la deuxième antenne RF,
les première partie d'antenne (AT2a) et deuxième partie d'antenne (AT2b) comprenant des spires de sorte qu'un courant induit global circule dans un même sens dans les spires de la première partie d'antenne AT2a et dans les spires de la deuxième partie d'antenne AT2b.

## Patentansprüche

1. Chipkarte (CD1), die Folgendes beinhaltet:
- einen Kartenkörper (6), der mindestens teilweise durch eine Metallschicht (8) gebildet ist, wobei die Metallschicht einen Aussparungsbereich (14) beinhaltet, der an einem Umfangsrand (8a) der Metallschicht mündet, wobei die Metallschicht einen Spalt beinhaltet, der den Aussparungsbereich mit dem Umfangsrand der Metallschicht verbindet;
- einen RF-Chip (4);
- eine erste RF-Antenne (AT1), die in oder gegenüber dem Aussparungsbereich angeordnet ist, wobei die erste RF-Antenne mit dem RF-Chip elektrisch verbunden ist; und
- eine zweite RF-Antenne (AT2), die Folgendes beinhaltet:
∘ einen ersten Antennenabschnitt (AT2a), der sich gegenüber der Metallschicht erstreckt, um einen Abbildungsstrom (I2a) zu erfassen, der durch erste Wirbelströme (I1a), die in der Metallschicht fließen, induziert wird; und
∘ einen zweiten Antennenabschnitt (AT2b), der mit dem ersten Antennenabschnitt (AT2a) elektrisch verbunden ist,
wobei der erste Antennenabschnitt (AT2a) und der zweite Antennenabschnitt (AT2b) Windungen beinhalten,
**dadurch gekennzeichnet, dass**:
- die zweite RF-Antenne (AT2) von der Metallschicht und der ersten RF-Antenne elektrisch isoliert ist;
- sich der zweite Antennenabschnitt (AT2b) gegenüber dem Aussparungsbereich erstreckt, um eine magnetische Kopplung (CL1) zwischen der ersten RF-Antenne und der zweiten RF-Antenne zu ermöglichen, und
- die Chipkarte einem induzierten Gesamtstrom (12) das Fließen in einer gleichen Richtung in den Windungen des ersten Antennenabschnitts AT2a und in den Windungen des zweiten Antennenabschnitts AT2b ermöglicht.

2. Chipkarte nach Anspruch 1, wobei die Wirbelströme unter der Einwirkung eines Magnetfelds (FL1) erzeugt werden, dem die Chipkarte ausgesetzt ist.

3. Chipkarte nach Anspruch 1 oder 2, wobei die zweite RF-Antenne so konfiguriert ist, dass sich der erste Antennenabschnitt gegenüber einem Randbereich der Metallschicht erstreckt.

4. Chipkarte nach einem beliebigen der Ansprüche 1 bis 3, wobei die zweite RF-Antenne so konfiguriert ist, dass sich der zweite Antennenabschnitt ausschließlich gegenüber dem Aussparungsbereich erstreckt.

5. Chipkarte nach einem beliebigen der Ansprüche 1 bis 4, wobei die erste RF-Antenne (AT1) so gegenüber dem Aussparungsbereich angeordnet ist, dass der Aussparungsbereich zwischen der ersten und der zweiten RF-Antenne (AT1, AT2) eingefügt ist, um eine magnetische Kopplung zwischen der ersten und der zweiten Antenne zu ermöglichen.

6. Chipkarte nach einem beliebigen der Ansprüche 1 bis 5, wobei die zweite RF-Antenne (AT2) durch eine Isolierschicht, die zwischen der zweiten RF-Antenne einerseits und der Metallschicht und dem Aussparungsbereich andererseits eingefügt ist, von der Metallschicht und der ersten RF-Antenne elektrisch isoliert ist.

7. Chipkarte nach einem beliebigen der Ansprüche 1 bis 6, wobei die Chipkarte ferner ein elektronisches Modul beinhaltet, das den RF-Chip umfasst, wobei das elektronische Modul in oder gegenüber dem Aussparungsbereich eingerichtet ist.

8. Chipkarte nach einem beliebigen der Ansprüche 1 bis 7, wobei der erste und der zweite Antennenabschnitt der zweiten RF-Antenne parallel zu einer kapazitiven Komponente geschaltet sind.

9. Chipkarte nach einem beliebigen der Ansprüche 1 bis 8, wobei die magnetische Kopplung dem RF-Chip ermöglicht, unter Verwendung der zweiten RF-Antenne, die mit der ersten RF-Antenne gekoppelt ist, eine kontaktlose Kommunikation zur Außenwelt der Chipkarte herzustellen.

10. Chipkarte nach einem beliebigen der Ansprüche 1 bis 9, wobei die Chipkarte CD1 frei von Ferrit ist.

11. Verfahren zur Fertigung einer Chipkarte (CD1) mit Hilfe eines Kartenkörpers (6), der mindestens teilweise durch eine Metallschicht (8) gebildet ist, wobei die Metallschicht einen Aussparungsbereich (14) beinhaltet, der an einem Umfangsrand (8a) der Metallschicht mündet, wobei die Metallschicht einen Spalt beinhaltet, der den Aussparungsbereich mit dem Umfangsrand der Metallschicht verbindet, wobei das Verfahren Folgendes beinhaltet:
- Bilden, auf oder in dem Kartenkörper, einer ersten RF-Antenne (AT1) in oder gegenüber dem Aussparungsbereich der Metallschicht;
- Anbringen eines RF-Chips (4) an dem Kartenkörper, sodass der RF-Chip (4) mit der ersten RF-Antenne elektrisch verbunden ist; und
- Bilden, auf oder in dem Kartenkörper, einer zweiten RF-Antenne (AT2), sodass die zweite RF-Antenne von der Metallschicht und der ersten RF-Antenne elektrisch isoliert ist, wobei die zweite RF-Antenne Folgendes beinhaltet:
∘ einen ersten Antennenabschnitt (AT2a), der sich gegenüber der Metallschicht erstreckt, um einen Abbildungsstrom (I2a) zu erfassen, der durch erste Wirbelströme (I1a), die in der Metallschicht fließen, induziert wird; und
∘ einen zweiten Antennenabschnitt (AT2b), der mit dem ersten Antennenabschnitt (AT2a) elektrisch verbunden ist und sich gegenüber dem Aussparungsbereich erstreckt, um eine magnetische Kopplung (FL1) zwischen der ersten RF-Antenne und der zweiten RF-Antenne zu ermöglichen,
wobei der erste Antennenabschnitt (AT2a) und der zweite Antennenabschnitt (AT2b) Windungen beinhalten, sodass ein induzierter Gesamtstrom in einer gleichen Richtung in den Windungen des ersten Antennenabschnitts AT2a und in den Windungen des zweiten Antennenabschnitts AT2b fließt.

## Claims

1. Smart card (CD1) comprising:
- a card body (6) formed at least in part by a metal layer (8), said metal layer comprising a cutout area (14) opening onto a peripheral edge (8a) of the metal layer, said metal layer comprising a slot connecting the cutout area to the peripheral edge of the metal layer;
- an RF chip (4);
- a first RF antenna (AT1) arranged in or opposite the cutout area, said first RF antenna being electrically connected to the RF chip; and
- a second RF antenna (AT2) comprising:
° a first antenna part (AT2a) extending opposite the metal layer to collect an image current (I2a) induced by first eddy currents (I1a) flowing in the metal layer; and
° a second antenna part (AT2b), electrically connected to the first antenna part (AT2a),
the first antenna part (AT2a) and the second antenna part (AT2b) comprising coils, **characterized in that**:
- the second RF antenna (AT2) is electrically insulated from the metal layer and from the first RF antenna;
- the second antenna part (AT2b) extends opposite the cutout area to allow a magnetic coupling (CL1) between the first RF antenna and the second RF antenna, and
- said smart card allows a global induced current (12) to flow in the same direction in the coils of the first antenna part AT2a and in the coils of the second antenna part AT2b.

2. Smart card according to Claim 1, wherein said eddy currents are produced under the effect of a magnetic field (FL1) to which the smart card is subject.

3. Smart card according to Claim 1 or 2, wherein the second RF antenna is configured so that the first antenna part extends opposite a peripheral area of the metal layer.

4. Smart card according to any one of Claims 1 to 3, wherein the second RF antenna is configured so that the second antenna part extends exclusively opposite the cutout area.

5. Smart card according to any one of Claims 1 to 4, wherein the first RF antenna (AT1) is arranged opposite the cutout area so that the cutout area is inserted between the first and second RF antennas (AT1, AT2) to allow a magnetic coupling between said first and second antennas.

6. Smart card according to any one of Claims 1 to 5, wherein the second RF antenna (AT2) is electrically insulated from the metal layer and from the first RF antenna by an insulating layer inserted between the second RF antenna on the one hand and the metal layer and the cutout area on the other hand.

7. Smart card according to any one of Claims 1 to 6, wherein the smart card also comprises an electronic module having the RF chip, said electronic module being positioned in or opposite the cutout area.

8. Smart card according to any one of Claims 1 to 7, wherein the first and second antenna parts of the second RF antenna are connected in parallel with a capacitive component.

9. Smart card according to any one of Claims 1 to 8, wherein the magnetic coupling allows the RF chip to establish contactless communication with the outside of the smart card by using the second RF antenna coupled to the first RF antenna.

10. Smart card according to any one of Claims 1 to 9, said smart card CD1 being devoid of ferrite.

11. Method for manufacturing a smart card (CD1) from a card body (6) formed at least in part by a metal layer (8), said metal layer comprising a cutout area (14) opening onto a peripheral edge (8a) of the metal layer, said metal layer comprising a slot connecting the cutout area to the peripheral edge of the metal layer, the method comprising:
- forming a first RF antenna (AT1) on or in the card body in or opposite the cutout area of the metal layer;
- installing an RF chip (4) on the card body so that the RF chip (4) is electrically connected to the first RF antenna; and
- forming a second RF antenna (AT2) on or in the card body so that the second RF antenna is electrically insulated from the metal layer and from the first RF antenna, the second RF antenna comprising:
° a first antenna part (AT2a) extending opposite the metal layer to collect an image current (I2a) induced by first eddy currents (I1a) flowing in the metal layer; and
° a second antenna part (AT2b), electrically connected to the first antenna part (AT2a), and extending opposite the cutout area to allow a magnetic coupling (FL1) between the first RF antenna and the second RF antenna, the first antenna part (AT2a) and the second antenna part (AT2b) comprising coils so that a global induced current flows in the same direction in the coils of the first antenna part AT2a and in the coils of the second antenna part AT2b.
